# EUROPEAN PATENT APPLICATION

(11) **EP 2 884 527 A2**
(43) Date of publication of application: **17.06.2015**
(21) Application number: 14195392.7
(22) Date of filing: 28.11.2014
(51) Int. Cl.: H01L 21/60, H01L 23/488

(54) **Semiconductor component and method for manufacturing semiconductor component**

(30) Priority: 12.12.2013 JP 2013256839
(71) Applicant: Kabushiki Kaisha Toshiba, Tokyo 105-8001 (JP)
(72) Inventor: Yamayose, Yuu, Tokyo, 105-8001 (JP); Kugimiya, Tetsuya, Tokyo, 105-8001 (JP); Hirohata, Kenji, Tokyo, 105-8001 (JP)
(74) Representative: Hoffmann Eitle

(57) **Abstract**

According to an embodiment, a semiconductor component includes a circuit board; a semiconductor chip; and a bond part formed by sintering a paste containing metal particles between the circuit board and the semiconductor chip to bond the circuit board and the semiconductor chip. The bond part includes a first area immediately under the semiconductor chip and a second area adjacent to the first area. The second area has a porosity equal to or lower than that of the first area.

## Description

### FIELD

Embodiments described herein relate generally to a semiconductor component and a method for manufacturing a semiconductor component.

### BACKGROUND

For higher efficiency and higher speed of semiconductor power devices, SiC power devices and GaN power devices different from Si power devices of related art have been developed globally. One of the characteristics of such next generation power devices is high-temperature operation. Si power devices are operated at a temperature of 150°C or lower owing to the restriction of heat resistance. With next generation power devices, however, high-temperature operation at 200°C or higher is possible.

Accordingly, there are also demands for higher heat resistance of bonding materials for die-mounting than that in the related art. Various new materials and new bonding methods have been developed, such as solder materials excellent in heat resistance and reliability at high temperatures having different compositions from those of the related art, and bonding methods in which an intermetallic compound layer with a high melting point is formed.

Most expected bonding methods include a sintering method using a metal particle sintering material that is sintered by heating and applying pressure to a metal particle paste, which contains metal particles having a particle size of nanometer or micrometer order and an organic protective film, etc.

With the technologies of the related art, however, bonding reliability may be lowered for such a reason that pressure is not properly applied to the metal particle paste, for example.

### BRIEF DESCRIPTION OF THE DRAWINGS

FIG. 1 is a cross-sectional view for explaining a semiconductor component according to a first embodiment;
FIG. 2 is a diagram illustrating a state of pressure application for forming a semiconductor component;
FIG. 3 is a diagram illustrating a state in which pressure is not applied to a periphery in the vicinity of a semiconductor chip;
FIG. 4 is a cross-sectional view illustrating an example of a semiconductor component;
FIG. 5 is a diagram illustrating an example of a pressurizing method in a sintering process;
FIG. 6 is a diagram illustrating an example of a pressurizing method in a sintering process according to the embodiment;
FIG. 7 is a graph illustrating relation between the distance from an end of a semiconductor chip and the stress value;
FIG. 8 is a diagram illustrating an example of the shape of a metal particle sintering material near the semiconductor chip;
FIG. 9 is a cross-sectional view for explaining a semiconductor component according to a second embodiment;
FIG. 10 is a diagram illustrating an example of an auxiliary member having a shape surrounding a semiconductor chip;
FIG. 11 is a diagram illustrating an example in which auxiliary members are mounted along the sides of the semiconductor chip;
FIG. 12 is a diagram illustrating an example in which auxiliary members are mounted along the sides of the semiconductor chip;
FIG. 13 is a cross-sectional view for explaining a semiconductor component according to a third embodiment;
FIG. 14 is a diagram of the semiconductor component according to the third embodiment as viewed from above;
FIG. 15 is a diagram for explaining an example in which disconnection is caused in a wiring structure; and
FIG. 16 is a cross-sectional view for explaining a semiconductor component according to a fourth embodiment.

### DETAILED DESCRIPTION

According to an embodiment, a semiconductor component includes a circuit board; a semiconductor chip; and a bond part formed by sintering a paste containing metal particles between the circuit board and the semiconductor chip to bond the circuit board and the semiconductor chip. The bond part includes a first area immediately under the semiconductor chip and a second area adjacent to the first area. The second area has a porosity equal to or lower than that of the first area.

Preferred embodiments of a semiconductor component and a method for manufacturing a semiconductor component will be described below in detail with reference to the accompanying drawings.

Hereinafter, a bonding method using a metal particle sintering material will be described. A metal particle sintering material having a particle size of nanometer or micrometer order is used, which allows sintering with a melting point far lower than bulk metal. A sinter structure has characteristics excellent in thermal conductivity and electrical conductivity with a high melting point. Examples of the metal particles include silver particles and copper particles.

The metal structure after sintering is a porous structure in which nanoparticles or microparticles are connected. The structure is thus completely different from that obtained by solder bonding or the like of the related art which is basically a dense structure except for mixture of voids and the like. It is therefore one of objects to ensure high bonding reliability of bonding through metal particle sintering.

In a study on the effect of sintering temperature and pressure applied during sintering of metal particle sintering on bonding reliability, it is found that the tensile strength of the structure resulting from sintering is higher as the sintering temperature is higher and that the shear strength of the structure resulting from sintering is higher as the pressure applied during sintering is higher.

Unlike solder bonding having a self-alignment effect due to wettability in the bonding process, the self-alignment effect cannot be expected in boding by metal particle sintering. Thus, to increase reliability, a metal particle paste is applied to an area larger than the chip size. Improvement in bonding strength by making the sinter structure denser by the applied pressure, however, is only effective in the area immediately under a chip to be mounted and a metal particle sinter structure to which pressure is not applied remains in a peripheral area of the chip. Thus, this is not necessarily effective for a fracture mode in which a crack is caused at a sinter structure with low strength around a chip and grows therefrom.

As described above, the bonding through metal particle sintering has a structure completely different from that of solder bonding and the like. It is therefore one of objects to ensure high bonding reliability of bonding through metal particle sintering.

Semiconductor components according to the embodiments below are semiconductor components having a semiconductor chip die-mounted on a substrate (circuit board) by using a metal particle sintering material. The semiconductor components of the embodiments may be in the form of semiconductor packages or the like.

The semiconductor components of the embodiments each has a semiconductor chip, a metal particle sinter bonding layer extending to a periphery in the vicinity of the semiconductor chip, and a substrate on which the semiconductor chip is mounted. In the embodiment, pressure is sufficiently applied to a metal particle paste present not only over the semiconductor chip but also in an outer area of the semiconductor chip in heating and pressurizing processes. As a result, the metal particle sinter bonding layer is formed to have an area (second area) having an average porosity equal to or lower than that of the metal particle sinter bonding layer (first area) immediately under the semiconductor chip in the periphery in the vicinity of the semiconductor chip. This improves the reliability of bonding between the substrate and the semiconductor chip.

### First Embodiment

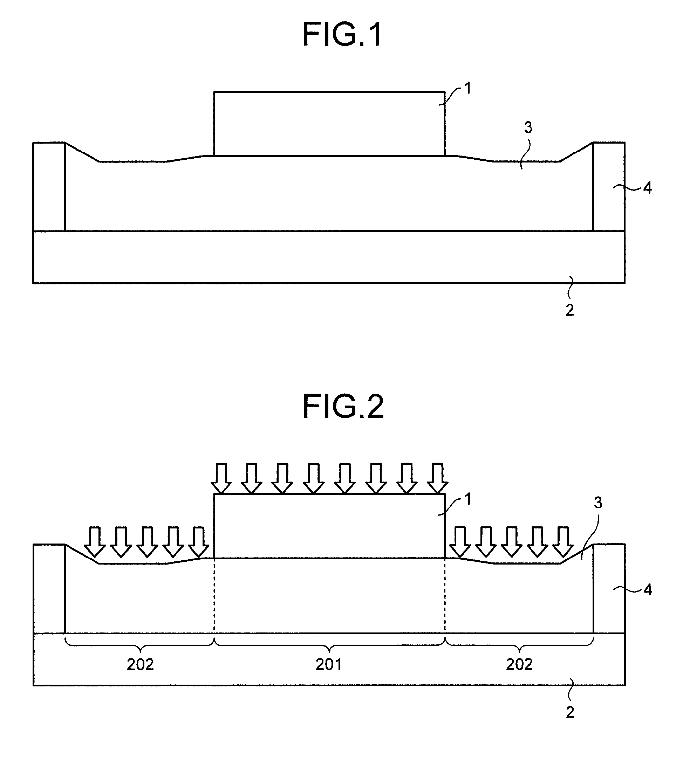

FIG. 1 is a cross-sectional view for explaining a semiconductor component according to a first embodiment. As illustrated in FIG. 1, the semiconductor component has a semiconductor chip 1 die-mounted by bonding through metal particle sintering mounted on a substrate 2. A bond part obtained by bonding through metal particle sintering includes a sinter structure 3 and a sinter structure 4. The sinter structure 3 is a part having a low porosity resulting from pressure application. The sinter structure 4 is a part having a porosity higher than that of the sinter structure 3 owing to insufficient pressure application.

FIG. 2 is a diagram illustrating a state of pressure application in forming a semiconductor component. As illustrated in FIG. 2, in the present embodiment, pressure is applied to the semiconductor chip 1 and to an area 202 of a metal particle paste under a periphery in the vicinity of the semiconductor chip 1. As a result, a dense sinter structure 3 is formed under the semiconductor chip 1 and in the area 202.

The area 202 is an area (second area) of the metal particle paste adjacent to an area 201 (first area) immediately under the semiconductor chip 1. The porosity (average porosity) of the area 202 is equal to or lower than that of the area 201 immediately under the semiconductor chip 1 as a result of pressure application. In addition, the area 202 includes an area having a thickness equal to or smaller than the thickness (average thickness) of the area 201. The area 202 may have any predetermined width (a distance from an end of the semiconductor chip 1) that can improve bonding reliability. As will be described later, the size of the area 202 may be within 100 µm from the end of the semiconductor chip 1, for example.

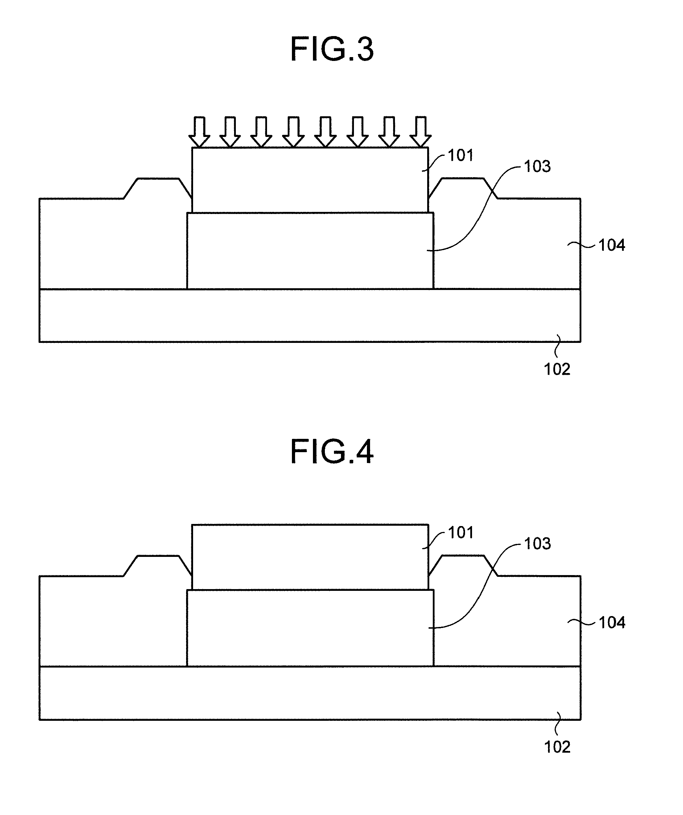

FIG. 3 is a diagram illustrating a state in which pressure is not applied to the periphery in the vicinity of the semiconductor chip. FIG. 4 is a cross-sectional view illustrating an example of the semiconductor component produced in this case. In the case where pressure is not applied to the periphery in the vicinity of a semiconductor chip 101 in the sintering process as illustrated in FIG. 3, a cross-section after sintering is as illustrated in FIG. 4. The metal particle sinter structure formed on a substrate 102 includes a dense sinter structure 103 and a sparse sinter structure 104 having a low strength in the periphery in the vicinity of the semiconductor chip 101.

Since stress is likely to be concentrated in the vicinity of the end of the semiconductor chip 101, a crack is likely to be caused in this area. Thus, in the semiconductor component produced as in FIG. 4, a crack may be caused in the sinter structure 104 having a low strength and grow therefrom.

In contrast, in the present embodiment, a dense metal particle sinter structure is also formed in the periphery in the vicinity of the semiconductor chip 1 as illustrated in FIG. 1 through application of pressure to the periphery. As a result, it is possible to improve the strength in the vicinity of the end of the semiconductor chip 1 where the risk for generation of a crack is high, and to reduce the risk at the bond part.

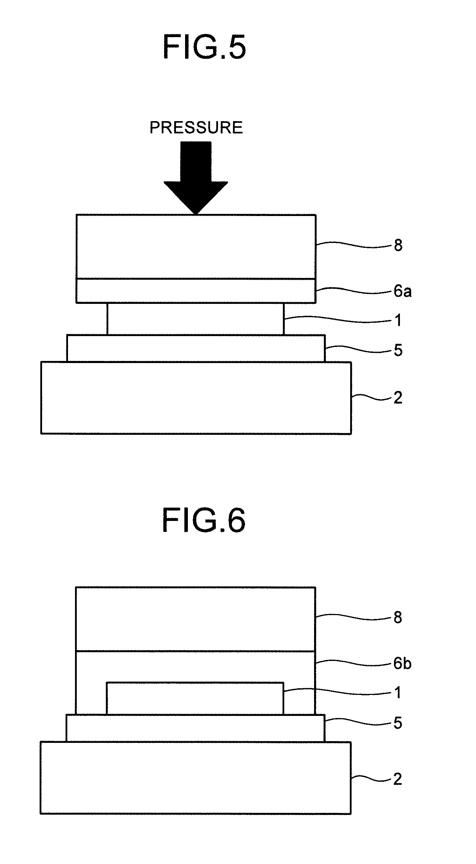

FIG. 5 is a diagram illustrating an example of a pressurizing method in a sintering process. In the sintering process, a metal particle paste 5 is placed on the substrate 2, and the semiconductor chip 1 is placed on the metal particle paste 5. Pressure is then applied by a pressure jig 8 via a buffer member 6a from above the semiconductor chip 1.

In bonding through metal particle sintering where pressure application is required, a soft buffer member 6a is often provided between the pressure jig 8 and the upper face of the semiconductor chip 1 as illustrated in FIG. 5 to make the applied pressure uniform over the entire surface of the semiconductor chip 1. The buffer member 6a is greatly deformed when pressure is applied, but a space remains in the vicinity of the semiconductor chip 1. As a result, pressure is not applied to the peripheral area of the semiconductor chip 1, and the metal particle sinter structure of the periphery in the vicinity of the semiconductor chip 1 is sparse as in FIG. 4.

Next, a method for applying pressure to the periphery as illustrated in FIG. 2 will be described. FIG. 6 is a diagram illustrating an example of a pressurizing method in a sintering process according to the present embodiment. FIG. 6 illustrates an example of a method in which the shape of the buffer member is devised. As illustrated in FIG. 6, a recess having substantially the same size as the semiconductor chip 1 is provided in the buffer member 6a in the present embodiment. This allows the metal particle paste under the periphery in the vicinity of the semiconductor chip 1 to be pressurized. The material selected for the buffer member 6a is a soft material excellent in elasticity such as rubber or graphene that is not bonded with the metal particle sintering material.

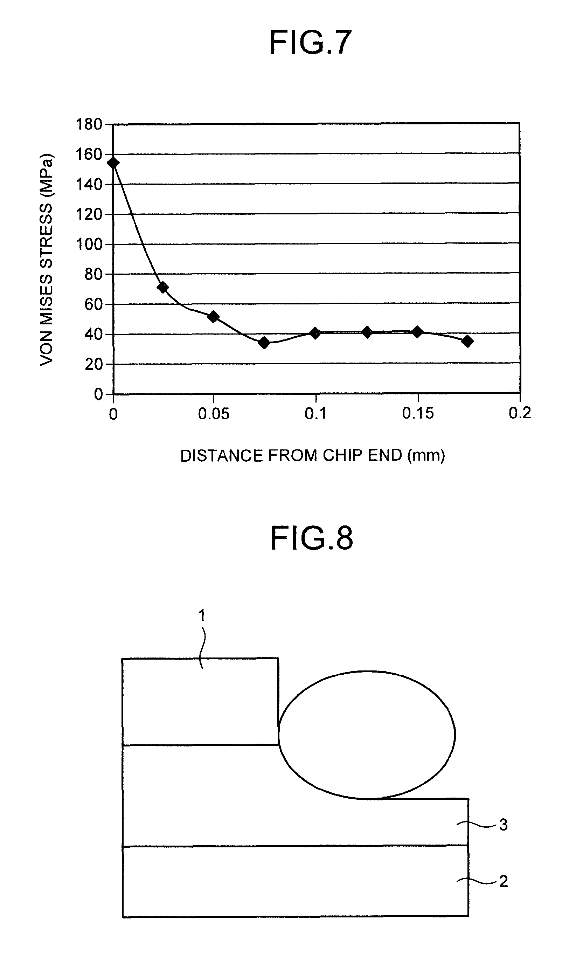

The size of the area to be pressurized in the periphery of the semiconductor chip 1 corresponds to the range of the end of the semiconductor chip 1 to which stress and strain concentrate. FIG. 7 is a graph illustrating an example of relation between the distance from the end of the semiconductor chip 1 and the stress value (von Mises stress). The stress value is a value of stress caused in the metal particle sinter structure. FIG. 7 is a graph obtained by simulating temperature variation of a simulated die-mounting structure, in which the horizontal axis represents the distance from the end of the semiconductor chip 1 and the vertical axis represents the stress value. This graph shows that the range of an area where the stress at the end of the semiconductor chip 1 is large is within 100 µm. For this reason, the size of the peripheral area of the semiconductor chip 1 where application of pressure is effective can be determined to be 100 µm from the end of the semiconductor chip 1.

Note that the value of 100 µm is only an example and the size is not limited thereto. Any value suitable for improving bonding reliability may be used depending on the material for the metal particles and the like. For example, a distance (a length from the end of the semiconductor chip 1) at which the stress value becomes a predetermined threshold or lower may be obtained by experiments or simulations, and pressure may be applied to the metal particle paste in an area for the obtained distance from the end of the semiconductor chip 1.

FIG. 8 is a diagram illustrating an example of the shape of the metal particle sintering material near the semiconductor chip 1. FIG. 8 illustrates an example in which the sinter structure 3 in the vicinity of the end of the semiconductor chip 1 has a fillet shape as a result of Poisson deformation of the buffer member 6b when pressure is applied. For example, the sinter structure 3 having the shape as illustrated in FIG. 8 can be formed by properly controlling the material for the buffer member 6b and the pressure applied during sintering. As a result of forming the sinter structure 3 to have such a shape, the stress concentration to the end of the semiconductor chip 1 can be reduced and the bonding reliability can be further improved.

The semiconductor component of the present embodiment is produced as follows, for example. First, a metal particle paste is placed on a substrate. Subsequently, a semiconductor chip 1 is placed on the metal particle paste. Subsequently, pressure is applied to the semiconductor chip 1 from above the semiconductor chip 1, pressure is applied to the metal particle paste from above an area (the periphery in the vicinity of the semiconductor chip 1) of the metal particle paste where the semiconductor chip 1 is not placed, and the metal particle paste is subjected to pressure sintering.

### Second Embodiment

In the first embodiment, application of pressure to the periphery in the vicinity of the semiconductor chip 1 is realized by devising the shape of the buffer member and the like. Alternatively, a dense metal particle sinter structure can be similarly formed under the periphery by mounting another member (auxiliary member) on the periphery.

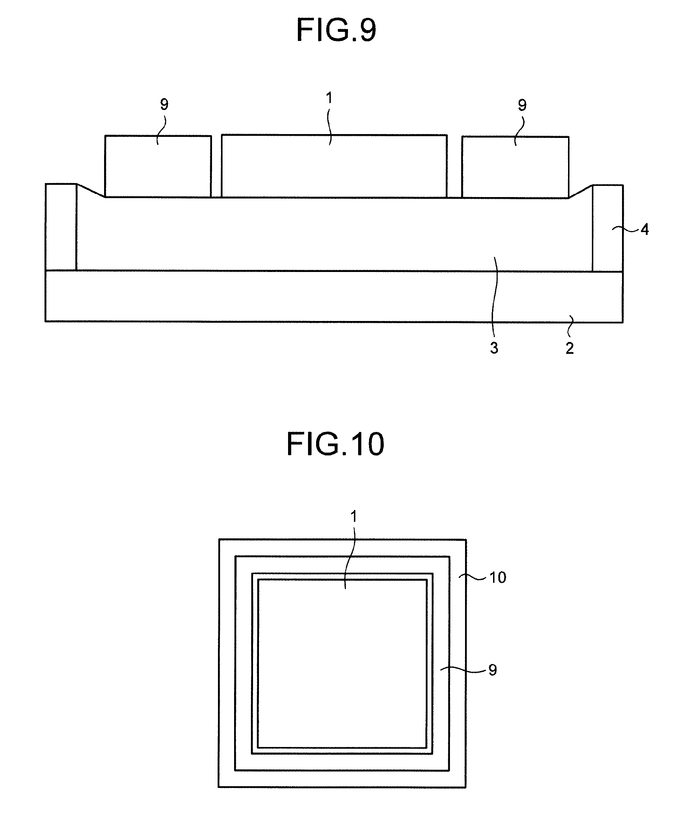

FIG. 9 is a cross-sectional view for explaining a semiconductor component according to a second embodiment. FIG. 9 illustrates a cross-sectional view of a case where an auxiliary member 9 is mounted on the periphery in the vicinity of the semiconductor chip 1. The auxiliary member 9 is formed on a surface, which faces the semiconductor chip 1, of an area (second area) adjacent to a metal particle sinter bonding layer (first area) immediately under the semiconductor chip 1. Even when the auxiliary member 9 is mounted, pressure is preferably applied via a buffer member to make the pressure uniform. The auxiliary member 9 may have various shapes.

FIG. 10 is a diagram illustrating an example of the auxiliary member 9 having a shape surrounding the semiconductor chip 1. As a result of using such an auxiliary member 9, the bonding reliability can be improved over the entire periphery of the semiconductor chip 1.

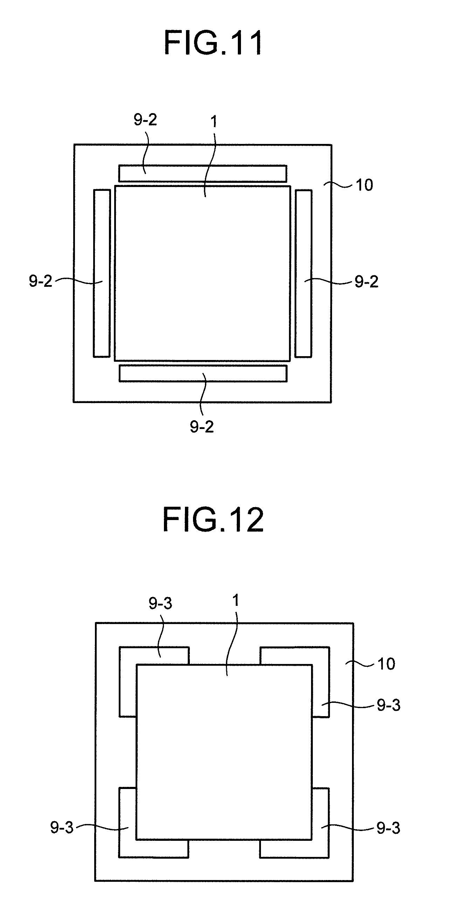

FIG. 11 is a diagram illustrating an example in which the auxiliary member is divided into multiple auxiliary members that are mounted along the sides of the semiconductor chip 1. As a result of dividing the auxiliary member into multiple auxiliary members 9-2 and arranging the auxiliary members 9-2 on a bond part 10 as illustrated in FIG. 11, a load due to a difference in the coefficient of thermal expansion between the mounted auxiliary members 92 and the substrate can be reduced. Furthermore, the load due to the difference in the coefficient of thermal expansion when the temperature changes is larger as the distance from the center of the semiconductor chip 1 is larger. Thus, the load reaches the maximum value in the vicinity of the corners of the semiconductor chip 1. Thus, a method of mounting L-shaped auxiliary members 9-3 in the vicinity of the corners of the semiconductor chip 1 where the load reaches the maximum value as illustrated in FIG. 12 is also effective.

### Third Embodiment

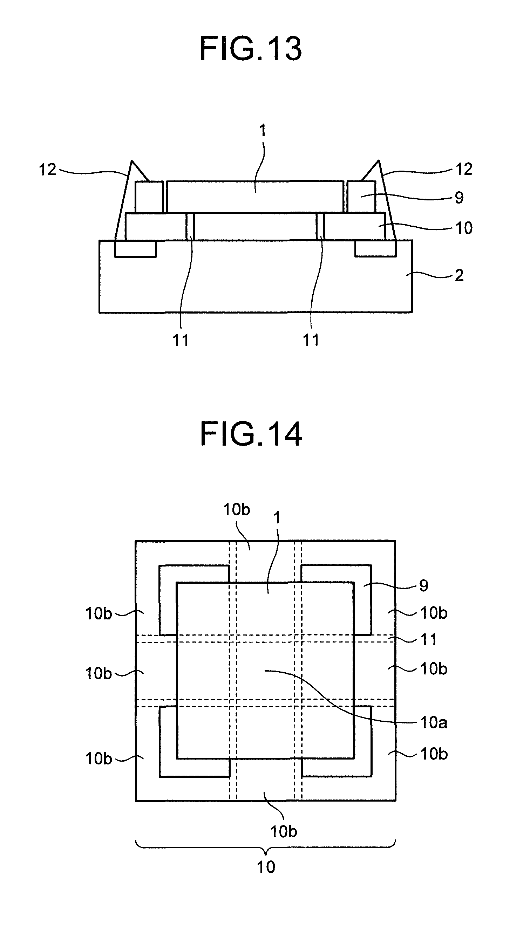

In the second embodiment, auxiliary members are mounted on the periphery in the vicinity of the semiconductor chip 1 to make the metal particle sinter structure under the periphery denser. In a third embodiment, an example in which the auxiliary members are used for detecting a predictor of failure of the bond part. FIGS. 13 and 14 illustrate an example in which the auxiliary members are used for detecting a predictor of failure. FIG. 13 is a cross-sectional view for explaining a semiconductor component according to the third embodiment. FIG. 14 is a diagram of the semiconductor component according to the third embodiment as viewed from above the semiconductor chip 1.

To detect a disconnection signal, grooves 11 are formed in the bond part 10 to divide the bond part 10 into central areas 10a and peripheral areas 10b as illustrated in FIG. 14. Furthermore, as illustrated in FIG. 13, the auxiliary members 9 are used to form a wiring structure 12 (connection path) aimed at detection of disconnection in the periphery of the semiconductor chip 1. In this case, conductive members are used for the auxiliary members 9.

For example, a measuring unit (not illustrated) provided inside or outside of the semiconductor component measures electrical properties of the wiring structure 12 to detect disconnection in the wiring structure 12. Examples of the electrical properties include electric resistance, current, and voltage.

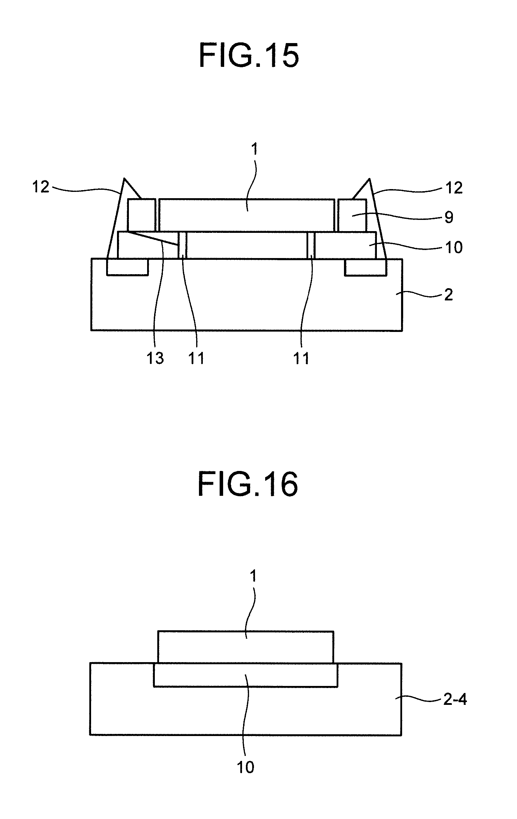

FIG. 15 is a diagram for explaining an example in which disconnection is caused in the wiring structure 12. If a crack 13 is caused in a lower portion of an auxiliary member 9 and disconnection occurs in the wiring structure 12 as illustrated in FIG. 15, a disconnection signal such as a change in the electric resistance can be detected. As a result, it is possible to detect a predictor of failure of the bond part 10. The detection of a predictor of failure can be used for early maintenance work, which is beneficial for improving robustness of a system using a semiconductor package.

### Fourth Embodiment

In a fourth embodiment, a method for forming a recess in an area immediately under a bond part die-mounted on a substrate will be described as another embodiment for making the metal particle sinter structure in the periphery in the vicinity of the semiconductor chip 1 denser.

FIG. 16 is a cross-sectional view for explaining a semiconductor component according to the fourth embodiment. A recess of a substrate 2-4 at least has a shape larger than that of the semiconductor chip 1. The semiconductor component of the present embodiment is produced as follows, for example. First, the recess of the substrate is filled with a metal particle paste. Subsequently, a semiconductor chip 1 is placed on the top of the metal particle paste. Subsequently, pressure is applied to the semiconductor chip 1 from above the semiconductor chip 1 to carry out pressure sintering. With such a method, pressure can also be applied to the metal particle sintering material in the periphery in the vicinity of the semiconductor chip 1 as a result of restricted walls of the recess, which can realize a denser sinter structure.

As described above, according to the first to fourth embodiments, sintering can be carried out with pressure also applied to a metal particle paste present in an area outside of a semiconductor chip. As a result, the strength in the vicinity of the end of the semiconductor chip can be improved, and the reliability of bonding between the substrate and the semiconductor chip can be improved.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor component comprising:
a circuit board;
a semiconductor chip; and
a bond part formed by sintering a paste containing metal particles between the circuit board and the semiconductor chip to bond the circuit board and the semiconductor chip, wherein
the bond part includes a first area immediately under the semiconductor chip and a second area adjacent to the first area, and
the second area has a porosity equal to or lower than that of the first area.

2. The component according to claim 1, wherein the second area includes an area with a thickness equal to or lower than an average thickness of the first area.

3. The component according to claim 1 or 2, further comprising an auxiliary member formed on a surface of the second area facing the semiconductor chip.

4. The component according to claim 3, wherein
the auxiliary member is conductive, and
the bond part and the auxiliary member constitute a connection path having electric properties that are measurable.

5. The component according to any one of the preceding claims, wherein
the circuit board has a recess, and
the bond part is formed by sintering the paste with which the recess is filled.

6. The component according to any one of the preceding claims, wherein the second area has a width of 100 µm or smaller.

7. A method for manufacturing a semiconductor component, comprising:
placing a paste containing metal particles on a circuit board;
placing a semiconductor chip on the paste; and
applying pressure to the semiconductor chip from above the semiconductor chip, applying pressure to the paste from above an area of the paste where the semiconductor chip is not placed, and sintering the paste.

8. The method according to claim 7, wherein
applying pressure to the semiconductor chip and the paste includes
applying pressure to the semiconductor chip and the paste so that a second area has a porosity equal to or lower than that of a first area, the first area being an area of the paste immediately under the semiconductor chip, the second area being an area of the paste adjacent to the first area.
